# EUROPEAN PATENT SPECIFICATION

(11) **EP 0 668 009 B1**
(45) Date of publication and mention of the grant of the patent: **09.10.1996**
(21) Application number: 94925372.8
(22) Date of filing: 19.07.1994
(51) Int. Cl.: H05K 7/18, H02B 1/30

(54) **SEALED METALLIC CABINET SET UP BY SYMMETRICAL PROFILE ELEMENTS, AND PROCESS FOR THE CONSTRUCTION OF THE PROFILE ELEMENTS**
ABGEDICHTETER METALLSCHRANK ZUSAMMENGESETZT VON SYMMETRISCHEN PROFILELEMENTEN, UND VERFAHREN UM EIN SOLCHES PROFILELEMENT HERZUSTELLEN
ARMOIRE METALLIQUE ETANCHE COMPOSEE PAR DES ELEMENTS PROFILES SYMMETRIQUES, ET PROCEDE DE CONSTRUCTION D'UN TEL ELEMENT PROFILE

(30) Priority: 17.12.1993 IT MI264593
(43) Date of publication of application: 23.08.1995
(73) Proprietor: Italtel Tecnomeccanica s.p.a., 05100 Terni (IT)
(72) Inventor: MARTELLI, Enzo, I-05100 Terni (IT); PUCCIARINI, Paolo, I-05100 Terni (IT)
(74) Representative: Giustini, Delio
(86) International application number: EP9402395
(87) International publication number: WO9517082

(56) References cited:
- EP-A- 0 538 540
- DE-U- 8 914 084
- US-A- 4 954 007

## Description

### Technical Field

This invention relates to a metallic sealing cabinet to contain electric and electronic equipment such as for example telecommunication apparatus or switch boards, control boards etc.

More precisely the invention relates to cabinets of the above-mentioned type realized with symmetrical frame sections, to the structures obtained by connecting two or more of such cabinets, as well as to a process for the construction of such symmetrical frame sections.

The case set up by the cabinet as a whole has to guarantee the protection of the contained elements from external environmental influence.

The degree of protection of cabinets of this type is internationally codified by IEC (International European Community) standards by two numbers for example by the mark IP 55. The first number indicates the degree of penetration of external objects while the second one indicates the penetration of liquids, generally water, and it varies between 0 and 6 passing from vertical dripping to the inclined one, to sprinkling, to jets and finally to complete immersion.

### Background Art

The Italian utility model application No. 22023 B/90 describes a sealing cabinet for electric equipment the framework of which is set up by frame sections with an open asymmetrical configuration (or which boundary edges of the origin sheet metal do not touch each other) providing for two perpendicularly arranged limbs which are connected by a plurality of right angle connection segments with the boundary edges of the limbs penetrating in gaskets. This section is not symmetrical and comprises limitations on the side sections suitable to receive a door or an openable panel provided with hinges.

Said limitations are inherent by the fact that due to the so-called asymmetry the front and side edges of the frame sections are not of the same dimensions so that it is difficult to apply hinge elements on one or the other edge unless using two different types of hinge elements the first of which for example to be matchable at the front edge while the other type is for example matchable at the side edge. In other words when using an asymmetrical section it is only possible to assure a perfect interchangeability of fixed and openable panels on all side sections of the cabinet by using two different types of hinge elements.

EP-A-0 538 540 describes symmetrical cabinet frame sections and formed by 8 subsequent portions, each folded at 90° with respect to the adjacent portions, and defining a box-like inner space somewhat resembling an L. While not disclosing in details the complete cabinet, EP-A-0 538 540 provides for a connection element for joining two adjacent cabinets built up with symmetrical members.

EP-A-0 144 955 upon which the preamble of claim 1 has been drafted describes a framework for an electric switchboard cabinet permitting expansion by mounting additional frame sections on all sides thereof. The cabinet framework comprises twelve interconnected frame sections of the same asymmetrical profile on which external panels and doors are installed provided with sealing gaskets. The cross section of the frame sections comprises a first (reference sign 13 in figure 1 of that patent application) and a second (14) external side sections which extend substantially in a perpendicular way to each other, and a first (12) and a second (11) internal side sections which extend substantially in a perpendicular way to each other, said first (13) and second (14) external side sections being connected to said first (12) and second (11) internal side sections by means of a first (19) and a second (15) connecting portions, the combination of said side sections (13, 14, 11, 12) setting up a square space (28) inside the frame sections.

EP-A-0 144 955 provides furthermore for an asymmetrical construction of the frame member which has a sealing strut (15-16) which is aligned with the internal side section 11 and adapted to compress edgewise a sealing gasket on a panel, and a further folded member (17-18) that is orthogonal to the side section 12 and is adapted to flatwise compress a sealing gasket between two adjacent cabinets. Therefore, when joining two adjacent panels to a same frame member two different type of connecting means are required, as it is evident from Figures 13 and 14 of that patent application in which a fastening block 63 for a hinged door is shown.

Namely, the panel 52 associated with the abutment web requires a gasket 71 which is flat-compressed by the folded member by means of a screw 57 turned in a threaded portion 55 of socket 54 whereas the panel 58 (a door in this case, but the fact has no relevance) is provided with a thicker gasket 72 which is edgewise compressed by the triple-thickness edge of portions 11, 15, 16.

When joining two frame sections together (see Fig. 14) a sealing gasket 70 is located between the abutment or sealing webs 17.5 and 17.6 and the whole surfaces of the gasket are flatwise compressed by the abutment webs through a screw threaded socket 68 and two opposite screws 56.

Thus, the choice of a not symmetrical section (which as a matter of fact makes simpler the joining of two adjacent cabinets) on the other hand requires the use of threaded sockets of different lengths and gaskets of different shapes.

The not symmetrical profile further involves (also with reference to the section of the above-mentioned utility model application) two different moment of inertia values compared to the axes X and Y in the cross section plane of the profile. As a consequence of the above-mentioned different values in case of bending and torsion stress there is unbalanced stress acting on the profile, so that its parts are stressed in a non uniform way.

Moreover the asymmetrical profile which main advantage is that of setting up a flange extending parallel to the side of the cabinet which is used in order to couple two cabinets together, involves a complex and expensive profile forming operation and needs additional elements such as a threaded coupling and further holes in the profile to introduce through those a tool to tighten the screws in the coupling and other holes in the webs to make the screws pass through.

Analogously to what previously reported with reference to the utility model application no. 22033 B/90, the asymmetry created by the above-mentioned flange introduces an additional limitation consisting in the impossibility to assure a perfect interchangeability of the fixed and openable panels on all side sections of the cabinet.

Finally DE-U-89 14 84 discloses a cabinet built up of frame sections of asymmetrical profile that resembles that of the above discussed EP-A-0 144 955, but including a triangular space inside the frame sections.

### Objects of the Invention

The objects of the present invention are to overcome the limitations and inconveniences of the prior art described before and in particular to realize a symmetrical section configuration without any difference between contact and sealing web, and thus easy to be produced at low costs allowing at the same time the sealed connection of two or more cabinets by means of the simple additional element.

### Disclosure of the Invention

The invention achieves these objects by a sealed metallic cabinet, especially for electric and electronic equipment as claimed in claim 1.

Moreover the invention consists in a structure, especially for electric and electronic equipment, comprising two or more metallic cabinets which are arranged in an adjacent and connected way, characterized in that between two parallel and opposite frame sections belonging to two adjacent frameworks a flange with an open M section is put, the legs of said flange provided with holes being abutted respectively on the external side sections of the symmetrical profiles of the two frame sections, said flange being fixed to blind threaded bushes applied to said external side sections by means of screws passing through holes of the flange, and further characterized in that a sealing gasket is put and edgewise compressed between said sealing struts of the two frame sections.

Finally the invention consists of a process for the manufacture of a symmetrical profile provided with an internal square space for the construction of cabinets starting from a plane metal sheet, said process being characterized by the steps of:
a) realizing a first bending of 90° in median position in order to form a dihedral which corner sets up the outer corner of the profile;
b) bending each one of the two side sections of the dihedral at 90° in intermediate position and in the opposite direction of said first bending in order to form the two external side sections of the profile;
c) bending each one of the end limbs of the folded metal sheet according to an angle of about 135° in the opposite direction with respect to the bendings of step b) in order to set up said first and second connecting portions, and
d) completing said last bendings by a further angle of about 45° up to the overlapping of said internal side sections to said connecting portions.

It will be evident to those skilled in the art that the particular shape of the symmetrical frame sections according to the invention makes it possible to obtain a double advantage inherent in the fact that it allows the use of a single type of hinge elements to assure the interchangeability of fixed and openable panels on all side sections of the cabinet, and in the fact that the moments of inertia with respect to the above-mentioned axes X and Y have the same value compared to the barycentre of the section, and therefore its parts are stressed in an uniform way even in case of flexure and torsional stress.

### Brief Description of the Drawings

The features of the present invention which are believed to be novel are set forth with particularity in the appended claims. The invention, together with further objects and advantages thereof, may best be understood by making reference to the following description taken together with the accompanying drawings, in which reference numerals identify the elements, and wherein:
- Fig. 1 shows schematically the structure of a cabinet according to the invention;
- Fig. 2 is a cross section illustrating the shape of the frame sections according to the invention
- Fig. 3 is a perspective view showing the coupling of the frame sections with the walls, according to the invention;
- Fig. 4 is a schematic cross section according to the line IV-IV of figure 6;
- Fig. 5 shows the junction between a corner and the end of a frame section;
- Fig. 6 is a partial view showing two frame sections and a corner of the cabinet according to the invention;
- Fig. 7 is a perspective view showing a structure set up by two placed side by side and connected cabinets;
- Fig. 7A shows the particular A of Fig. 7;
- Fig. 8 is a partial view from above of the structure in Fig. 7;
- Fig. 9 is a cross section according to line IX-IX in Fig. 7;
- Fig. 9A shows the cross section of the gasket "at rest"; and
- Fig 10A to 10E show the steps of the manufacture process of the frame sections.

### Detailed Description of the Preferred Embodiment

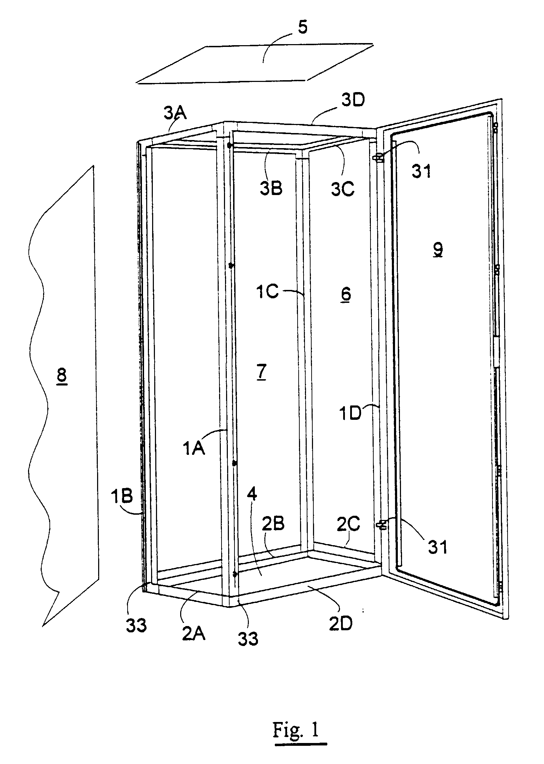

Referring initially to Fig. 1 a cabinet according to the invention comprises a framework set up by frame sections connected at their ends and by a certain number of fixed and mobile panels or doors. More exactly in the embodiment shown in Fig. 1 the framework includes four vertical frame sections 1A, 1B, 1C, 1D, four lower horizontal frame sections 2A, 2B, 2C, 2D, and four upper horizontal frame sections 3A, 3B, 3C, 3D.

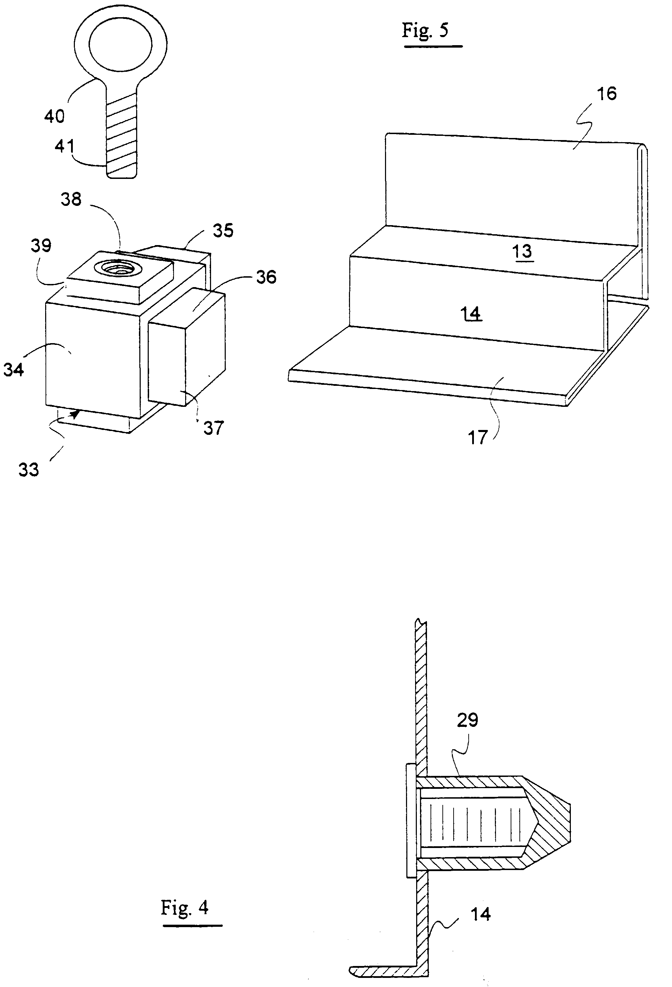

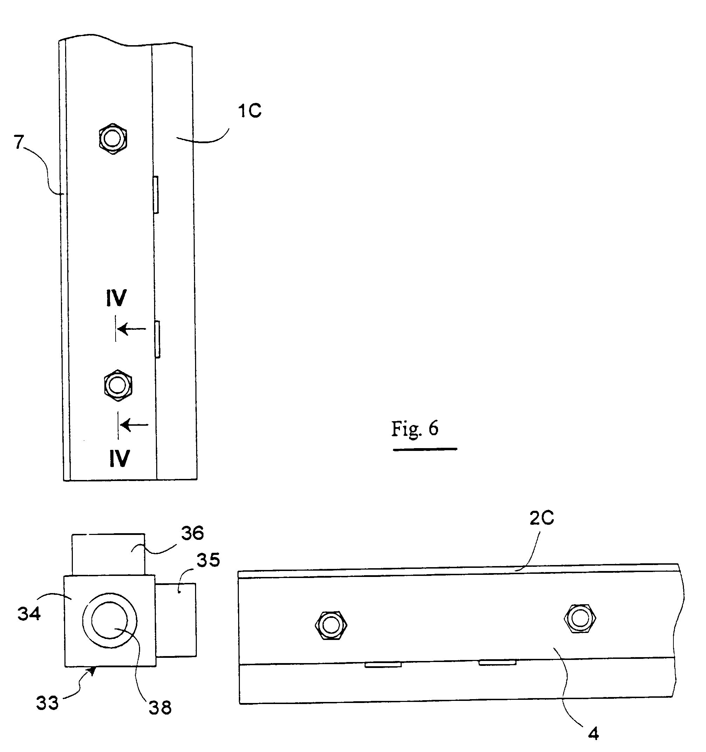

The framework is closed by a bottom panel 4, a top panel 5, three fixed side panels 6, 7 and 8, and by a panel 9 provided with hinges 31 setting up an openable panel or door. The frame sections are connected in groups of three by angular blocks or corners 33 which construction will be shown in a more detailed way hereafter with reference to Fig. 5 and 6.

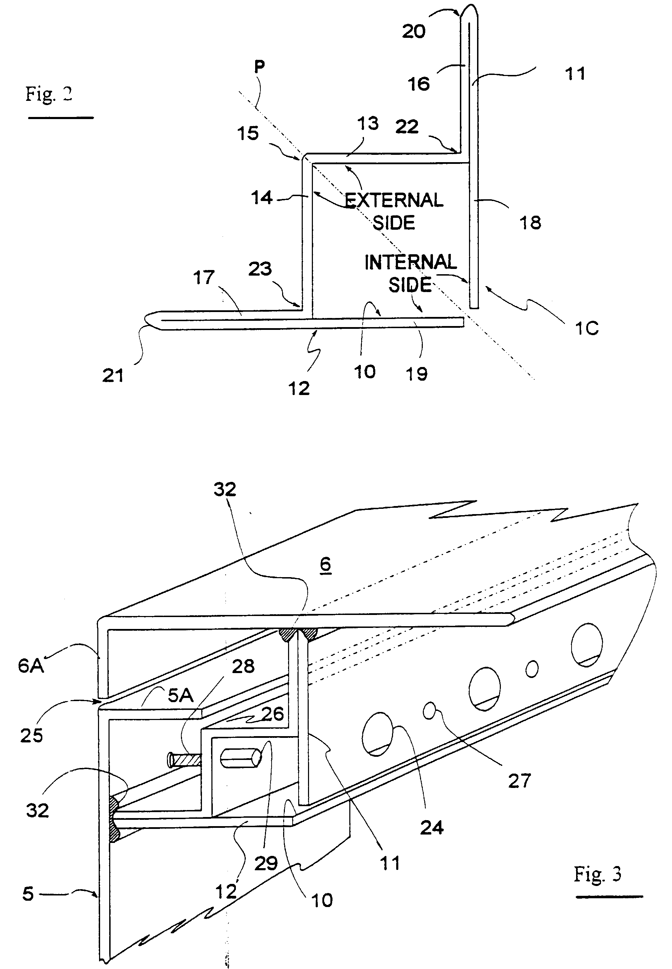

The cross section of the frame sections or profile according to the invention is shown in Fig. 2. Said profile is set up by a metal sheet by means of folding and refolding.

In the present description the term "folding" or "bending" is used to indicate a deformation of the metal sheet at about 90°, while the term "refolding" indicates a double bending or deformation which makes the sheet metal bend on itself by overlapping. Finally the term "beading" means a refolding of the sheet where the sheet metal lies on itself overlapping the double thickness of the refolded sheet in order to lock the folds together. For simplicity reasons the same reference will be used in the description to indicate either a bending (or refolding) or the relevant corner set up by this operation.

Moreover a section is considered to be "open" when the ends edges of the single metal sheet it is set up by are "distant" and "closed" in the contrary case. Consequently an at one end overlapped profile obtained by beading is considered a closed one. When both ends substantially are mechanically not bound to each other, the section has to be defined as being "not closed".

Therefore the profile of the present invention turns out being "not closed" and "without beading".

Coming back to the profile of the present invention shown in Fig. 2 this is set up by a single folding and refolding metal sheet comprising:
- a first external side section 13 and a second external side section 14 set up with the same length and externally connected by the external corner set up by a bending at 90° identified by reference numeral 15;
- a first connecting portion 16 and a second connecting portion 17 with the same length and connected to said external side section 13 and 14 by means of two bendings at 90° identified by reference numerals 22 and 23;
- a first internal side section 11 and a second internal side section 12 set up with the same length and being substantially perpendicularly arranged to each other.

The end edges of said first 16 and second 17 connecting portions together with the end edges of said first 11 and second 12 internal side sections form portions of double thickness whose ends, identified by reference numerals 20 and 21, set up sealing struts which will be more clear with reference to Fig. 3.

The external side sections 13 and 14 in combination with the portions 18 and 19 of the respective internal side sections 11 and 12 set up a substantially square space 10, or a channel with a square cross section extending for the whole profile.

The profile according to the invention is therefore symmetrical with respect to the diagonal plane P passing through and bisecting the intersection angle of the planes containing the external side sections 13, 14.

As better visible in Fig. 3 and 4, alternating holes with different diameters 24 and 27 on the portions 18 and 19 of the internal side sections are set up for the insertion and fastening of (not shown) internal elements like shelves and sections at a preset metrical pitch either by means of insertion of bushes or by the application of self-threading screws.

Moreover in the external side sections 13 and 14 of the profile, holes are set up to receive blind threaded bushes 29. One of these bushes is shown (in cross section) in Fig. 4 and (visible) in Fig. 6. These bushes receive the ends of screws 28 for the fixing of panels on the profile passing through the panel and one of the external walls (see Fig. 3).

Thanks to this arrangement in case a screw is taken off or lost the tightness of the portions 18 and 19 is not endangered.

Fig. 3 illustrates the connection modality of the parts which make up the cabinet according to the invention. As can be seen in the figure, panels 5 and 6 which are for example fixed on side section 1C are set up by metal sheets which are bent substantially at 90° along the edge to form two limbs 5A and 6A, respectively, with a minor length compared to the length of said connecting portions 16 and 17 of the profile. The panels are bound to the profile by means of the screws 28 or in case of mobile panels or doors by means of hinges 31.

On the internal surface of the panels 4-8 and of the door 9 a gasket 32 of foamed elastomer material for example rubber is put which is compressed by the end edge 20, 21 of one of side sections setting up said sealing struts, when the panel is fixed by means of screws 28 or - in case of the door - when this one is closed.

As it can be seen in Fig. 3, the tab 5A and the final part of panel 5 close nearly completely the flank with the exception of small interspaces 25 giving access to a first internal space (delimited by panel 6 and by the frame section), and through a second interspace 26 set up between the free edge 5A and the edge 15 to a second internal space (delimited by panel 5 and the frame section). The part of the profile according to the invention set up by the elements 13, 14, 16 and 17 (external portion of the profile) is without any openings and holes, and consequently the structure realizes an eave effect which interrupts the water jet and creates a difficult passage towards the interior and allows then the water to flow downwards.

The profiles setting up the framework of the cabinet are connected by corner elements 33 shown in a more detailed way in Fig. 5 and 6.

Each one of said couplings or corner elements 33 is set up as a block with a central body 34 of cubic shape from which three appendixes 35, 36 and 37 are extending with a square cross section and corresponding to the size of the square space 10 of the profile. The appendixes are inserted in the spaces of three frame sections then welded.

Moreover body 34 provides for a threaded hole 38 into which the threaded end 41 of an eyebold 40 for the lifting of the cabinet or a lifting foot can be screwed (not shown).

According to the invention the body 33 of the block presents moreover a projecting part 39 on the face with the thread 38 for the eyebold or for a lifting foot. In this way it is avoided to put in a spacer between the roof or the upper panel 5 and the block or between the lower panel 4 and the block, a spacer which would be necessary to give the correct pressure to tighten the eyebold or the lifting foot.

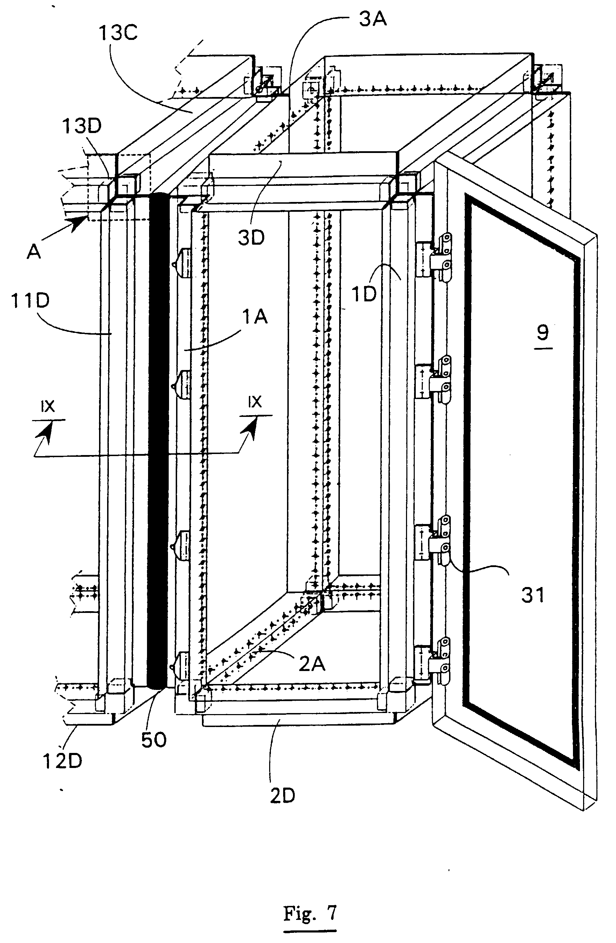

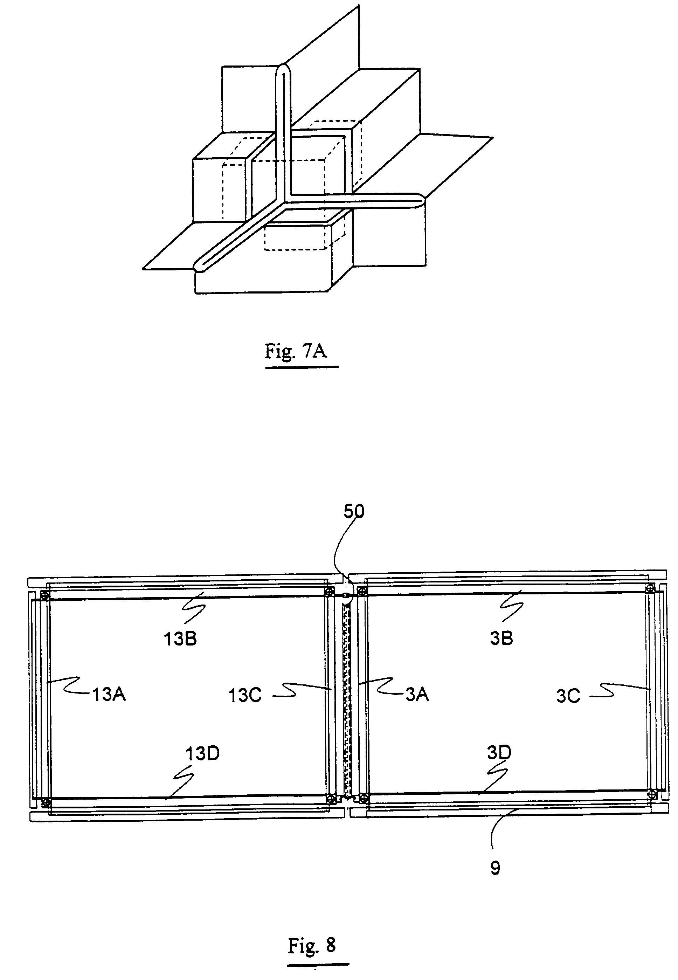

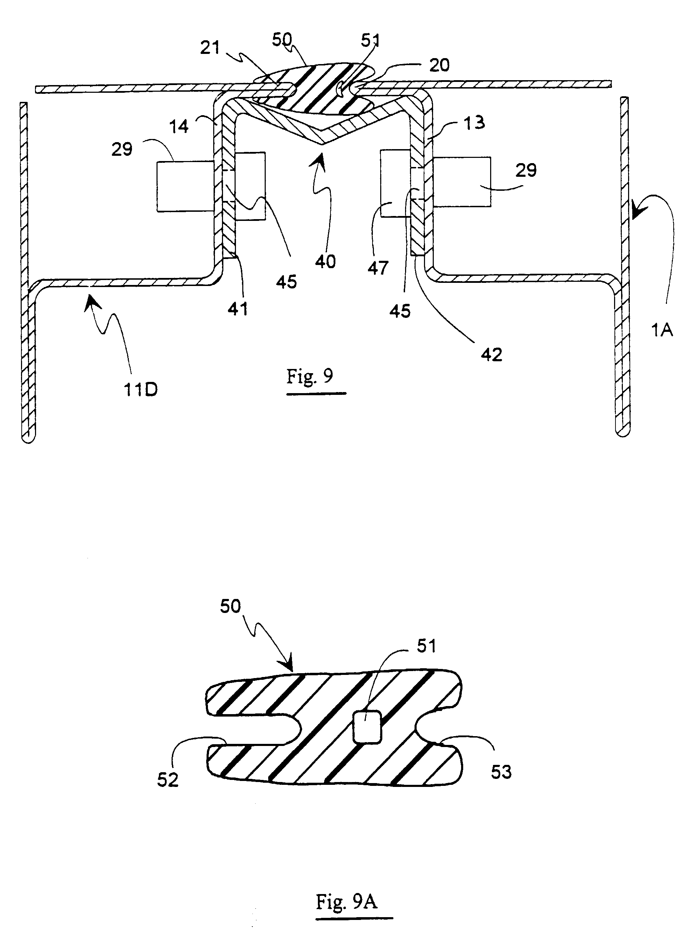

Fig. 7 shows in partial perspective a structure according to the invention set up by two cabinets which are placed side by side and bound together, one of them is for illustrative clearness reasons only partially shown. Fig. 7A shows a particularity indicated by box A of Fig. 7, while Fig. 9 is a cross section according to line IX-IX of Fig. 7 showing in a more detailed way the coupling of two cabinets.

For the frame sections setting up one of the cabinets the same numerical references of Fig. 1 have been used while for the frame sections of the adjacent one the numerical references of corresponding parts are used but increased by 10. For the single elements of the profile the same symbols of Fig. 2 are used with the possible indication of the frame section (or of the cabinet) they belong to.

Between the two profiles 1A and 11D placed side by side and belonging to the two adjacent cabinets, a flange 40 with an M-shaped cross section is put (see Fig. 9), which side sections or legs 41 and 42 are placed against the external side sections 14 and 13, respectively, of the symmetrical frame sections of two adjacent cabinets. On the side sections 41 and 42 of flange 40, holes 45 are foreseen through which screws 47 pass which engage in the blind threaded bushes 29 and bind the two cabinets together. A gasket 50 made of rubber or similar material is put and compressed between the edges 20 and 21 of the frame sections. The gasket 50, shown in its rest condition in Fig. 9A, has a cross section shape which is substantially rectangular with a slight tapering on the two boarders and provides for an internal tailrace 51 and two opposed side channels between which the ends edges 20 and 21 of the profiles are arranged in order to create a sealing strut.

A similar arrangement is naturally foreseen between the upper horizontal side sections as illustrated in the partial view from above of Fig. 8 and between the other couples of either horizontal or vertical adjacent side sections.

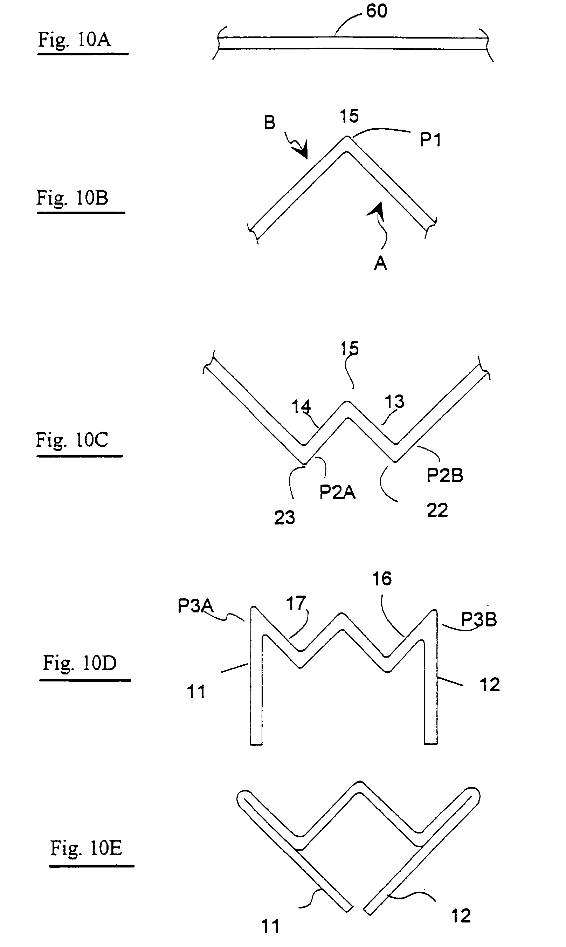

Fig. 10A to 10E show the steps of the process leading to the setting up of the symmetrical profile according to the invention. In the Figures, reference numerals are moreover progressively indicated in brackets which are assigned to the final portions of the frame section.

Fig. 10A shows the original plane metal sheet identified by reference numeral 60. This sheet undergoes a first bending P1 at 90° in median position setting up the external edge 15 of the profile. The sheet takes therefore the dihedral configuration shown in Fig. 10B.

Each one of the two side sections of the dihedral A and B undergoes a second bending at 90° indicated by P2A and P2B, respectively, in the direction opposed to the bending P1 in order to set up the two external side sections 13 and 14 and the edges 22 and 23. The sheet gets the intermediate configuration with an overturned W-shaped cross section shown in Fig. 10C.

Each one of the end limbs of the "W" thus undergoes a bending of about 135° indicated by P3A and P3B, respectively, in the direction opposed to that of the previous bendings P2A and P2B forming the portions 16 and 17. The sheet 60 get in this way a configuration similar to that of an M with divided and overturned summit as shown in Fig. 10D in which the side sections are the origin of the internal side sections 11 and 12.

The bendings P3A and P3B are therefore carried on for a further 45° up to the overlapping of part of the bent side sections and in order to set up an angle of 90° between the edges of the internal side sections 11 and 12 which anyhow are not put together or beaded, considering that an airgap is formed between said internal side sections (Fig. 10E).

The whole construction of the profile is realized by using a conventional machine like a so-called universal bending machine without the need of modifying the machine tooling.

The invention achieves different and important advantages compared to the structures of the prior art.

Using a piece of symmetrical profile, a unique type of profile is necessary to construct all segments composing the framework.

Moreover it turns out to be possible to apply doors even in side positions without modifications, and the cabinet is accessible from the bottom.

Besides this, thanks to the symmetry of the profile according to the invention, a cabinet structure set up by it reacts in a homogeneous way to either static or dynamic torsion stress as the symmetry includes a constant moment of inertia. This improves the general reaction of the cabinet to potentially dangerous stresses like heavy loads, lifting of the cabinet etc. without deformations.

According to the invention the frame sections are symmetrical and therefore realizable in a simple and economic way by means of conventional bending machines without the need of modifying the equipment. The junction of two or more cabinets requires only the presence of a simple M-shaped flange.

Even the construction of the profile turns out to be simplified as it foresees a reduced number of bendings and refoldings, in particular seven, and being free of overlappings (beadings).

Although the invention has been described referring in particular to a preferred embodiment it will be understood by those skilled in the art that various other modifications and changes may be made to the present invention without departing from the scope thereof as defined in the appended claims.

## Claims

1. Sealed metallic cabinet, especially for electric and electronic equipment comprising a framework set up by twelve interconnected frame sections of the same profile on which external panels (4, 5, 6, 7, 8) and doors (9) are installed provided with sealing gaskets, the cross section of the frame sections comprising a first (13) and a second (14) external side sections which extend substantially in a perpendicular way to each other, and a first (11) and a second (12) internal side sections which extend substantially in a perpendicular way to each other, said first (13) and second (14) external side sections being respectively connected to said first (11) and second (12) internal side sections by means of a first (16) and a second (17) connecting portions which are joined to said first (13) and second (14) external side sections by means of two bendings at 90°, the combination of said side sections (13, 14, 11, 12) setting up a square space (10) inside the frame sections,
characterized in that:
- said profile is symmetrical with respect to the diagonal plane (P) passing through and bisecting the intersection angle of the planes containing said external side sections (13, 14);
- the end edge of said first (16) connecting portion in cooperation with and connected to the end edge of said first (11) internal side section and the end edge of said second (17) connecting portion in cooperation with and connected to the end edge of said second (12) internal side section form respective and equal sealing struts (20, 21), each capable to edgewise compress either a sealing gasket (32) of said external panels (4, 5, 6, 7, 8) and door (9) or a gasket (50) located between two laterally joined cabinets.

2. Sealed metallic cabinet according to claim 1, characterized in that said profile is realized by means of a single metal sheet with free end edges of the sheet remaining substantially in an adjacent position but being not mechanically connected along the intersection line of the planes containing said internal side sections (11, 12).

3. Sealed metallic cabinet according to claim 1 or 2, characterized in that on said external side sections (13, 14) of the profile holes are set up receiving blind threaded bushes (29) which apply to the ends of the screws (28) fixing the panels (4 - 8) at the frame sections.

4. Sealed metallic cabinet according to claim 3, characterized in that said panels (5, 6) are set up by metal sheets which are bent substantially at 90° along the edges to set up limb portions (5A, 6A).

5. Sealed metallic cabinet according to claim 3, characterized in that said door (9) is set up by a metal sheet bent substantially at 90° along the edges to set up limb portions and fixed by means of hinges (31) to the frame work in correspondence to the external sides of the profile.

6. Sealed metallic cabinet according to claim 3 or 4, characterized in that it is provided in correspondence to the corners with an eave or labyrinth structure set up by contiguous panels, by their limb portions (5A, 6A) and by the frame sections on which said panels are installed.

7. Sealed metallic cabinet according to claim 6, characterized in that said labyrinth comprises a first passage (25) defined between the limb portions of a panel (5, 6) and of a panel or of an adjacent door (9), and a second passage (26) set up between the free edge (5A) of a panel or the external corner (15) formed by said first (13) and second (14) external side sections.

8. Sealed metallic cabinet according to the preceding claims, characterized in that the frame sections (1A, 1B, 1C, 1D, 2A, 2B, 2C, 2D, 3A, 3B, 3C, 3D) setting up the framework are connected by welded coupling elements (33).

9. Sealed metallic cabinet according to claim 8, characterized in that each one of said coupling elements or junction elements (33) is set up like a block with a central body (34) of a cubic shape from which three appendixes (35, 36 and 37) extend with a square section corresponding to the dimensions of said square space (10) of the profile.

10. Sealed metallic cabinet according to claim 9, characterized in that said central body (34) is provided with a threaded hole into which the threaded end (41) of an eyebold (40) for the lifting of the cabinet or a lifting foot can be screwed, and is provided furthermore with a projecting part (39) on the face with said threaded hole (38).

11. Sealed metallic cabinet according to the preceding claims, characterized in that on the portions (18, 19) of said internal side sections (11, 12) holes (24, 27) of different and alternating diameters are set up.

12. Structure, especially for electric and electronic equipment, comprising two or more metallic cabinets according to one of the preceding claims, which are arranged in an adjacent and connected way, characterized in that between two parallel and opposite frame sections (1A, 11D) belonging to two adjacent frameworks a flange (40) with an open M section is put, the legs (41, 42) of said flange (40) provided with holes (45) being abutted respectively on the external side sections (13, 14) of the symmetrical profiles of the two frame sections (1A, 11D), said flange (40) being fixed to blind threaded bushes (29) applied to said external side sections (13, 14) by means of screws passing through said holes (45) of the flange, and further characterized in that a sealing gasket (50) is put and edgewise compressed between said sealing struts (20, 21) of the two frame sections (1A, 11D).

13. Structure according to claim 12, characterized in that said sealing gasket (50) has a substantially rectangular cross section with a slight tapering on two sides and foresees an internal tailrace (51) and two opposed side channels (52, 53) between which the said sealing struts (20, 21) are arranged.

14. Process for the manufacture of a symmetrical profile provided with an internal square space (10) for the construction of cabinets according to one of the claims from 1 to 11 starting from a plane metal sheet (60), said process being characterized by the steps of:
a) realizing a first bending of 90° (P1) in median position in order to form a dihedral which corner sets up the outer corner (15) of the profile;
b) bending (P2A, P2B) each one of the two side sections of the dihedral at 90° in intermediate position and in the opposite direction of said first bending (P1) in order to form the two external side sections (13, 14) of the profile (10);
c) bending (P3A, P3B) each one of the end limbs of the folded metal sheet according to an angle of about 135° in the opposite direction with respect to the bendings (P2A, P2B) of step b) in order to set up said first (16) and second (17) connecting portions, and
d) completing said last bendings (P3A, P3B) by a further angle of about 45° up to the overlapping of said internal side sections (11, 12) to said connecting portions (16, 17).

15. Process according to claim 14, characterized in that step d) is realized by pressing said internal side sections (11, 12) against said connecting portions (16, 17).

## Patentansprüche

1. Abgedichteter Metallschrank besonders geeignet zur Unterbringung elektrischer und elektronischer Apparaturen, der aus einer Rahmenstruktur besteht, welche sich aus zwölf miteinander verbundenen Rahmenschenkeln mit gleichem Profil zusammensetzt, versehen mit Abdichtungen, auf denen Aussenpaneele (4, 5, 6, 7, 8) und Türen (9) angebracht werden, wobei der Querschnitt der Rahmenschenkel einen ersten (13) und einen zweiten (14) Aussenseitenschenkel umfaßt, die im wesentlichen senkrecht zueinander stehen, sowie einen ersten (11) und einen zweiten Innenseitenschenkel, die im wesentlichen senkrecht zueinander stehen, wobei der genannte erste (13) zweite (14) Aussenseitenschenkel mit dem genannten ersten (11) beziehungsweise zweiten (12) Innenseitenschenkel durch ein erstes (16) und ein zweites (17) Verbindungsstück verbunden sind, welche mit dem genannten ersten (13) und zweiten (14) Aussenseitenschenkel durch zwei rechtwinklige Biegungen verbunden sind, wobei die Zusammensetzung der genannten Seitenschenkel (13, 14, 11, 12) einen quadratischen Hohlraum (10) im Innern der Rahmenschenkel bilden,
dadurch gekennzeichnet, daß:
- das genannte Profil symmetrisch im Vergleich zur diagonalen Ebene (P), die durch den Schnittwinkel der Ebene, der die genannten Aussenschenkel (13, 14) umfaßt, läuft und diesen halbiert;
- die Abschlußkante des genannten ersten (16) Verbindungsstücks in Zusammenhang mit und verbunden mit der Abschlußkante des genannten ersten (11) Innenseitenschenkels und der Abschlußkante des genannten zweiten (17) Verbindungsstücks in Zusammenhang mit und verbunden mit der Abschlußkante des genannten zweiten (12) Innenseitenschenkels bilden die entsprechenden und gleichen Dichtungsstreifen (20, 21), wobei jeder geeignet ist, seitlich entweder eine Abdichtung (32) der genannten Aussenpaneele (4, 5, 6, 7, 8) und Türen (9) oder eine sich zwischen zwei aneinander gesetzten Schränken befindliche Dichtung (50) anzudrücken.

2. Abgedichteter Metallschrank nach Anspruch 1, dadurch gekennzeichnet, daß das genannte Profil durch ein einziges Blechstück gebildet wird mit freien Abschlußkanten des Blechs, welche im wesentlichen in einer angrenzenden Stellung verbleiben ohne jedoch entlang der Schnittlinie der Ebenen, die die genannte Innenseitenschenkel (11, 12) umfassen, mechanisch miteinander verbunden zu sein.

3. Abgedichteter Metallschrank nach Anspruch 1, dadurch gekennzeichnet, daß auf den genannten Aussenseitenschenkeln (13, 14) des Profils Löcher angebracht sind, welche Gewindehülsen (29) aufnehmen, die den Enden der Schrauben (28) entsprechen, mit denen die Paneele (4 - 8) an den Rahmenschenkeln befestigt werden.

4. Abgedichteter Metallschrank nach Anspruch 3. dadurch gekennzeichnet, daß die genannten Paneele (5, 6) aus Blechen bestehen, die entlang den Kanten rechtwinklig gebogen sind, um Anlageschenkel (5A, 6A) zu bilden.

5. Abgedichteter Metallschrank nach Anspruch 3, dadurch gekennzeichnet, daß die genannte Tür (9) aus einen Metallblech besteht, das entlang den Kanten im wesentlichen rechtwinklig gebogen ist, um Anlageschenkel zu bilden und die mittels Scharnieren an der Rahmenstruktur in Übereinstimmung mit den Innenseiten des Profils angebracht werden.

6. Abgedichteter Metallschrank nach Anspruch 3 oder 4, dadurch gekennzeichnet, daß er in Übereinstimmung mit den Ecken mit einer Rinnen- oder Labyrinthstruktur versehen ist, die durch angrenzende Paneele, durch ihre Anlageschenkel (5A, 6A) und durch die Rahmenschenkel, an denen die genannten Paneele angebracht sind, gebildet werden.

7. Abgedichteter Metallschrank nach Anspruch 6, dadurch gekennzeichnet, daß das genannte Labyrinth eine erste Passage (25) einschließt, die zwischen den Anlageschenkeln eines Paneels (5, 6) und einem anderen Paneel oder einer angrenzenden Tür (9) definiert wird, und eine zweite Passage (26), welche zwischen der freien Kante (5A) eines Paneels oder der Außenkante (15) gebildet wird, die ihrerseits durch den genannten ersten (13) und zweiten (14) Aussenseitenschenkel gebildet wird.

8. Abgedichteter Metallschrank nach den vorstehenden Ansprüchen, dadurch gekennzeichnet, daß die Rahmenschenkel (1A, 1B, 1C, 1D, 2A, 2B, 2C, 2D, 3A, 3B, 3C, 3D), die die Rahmenstruktur bilden, durch geschweißte Kupplungselemente (33) verbunden sind.

9. Abgedichteter Metallschrank nach Anspruch 8, dadurch gekennzeichnet, daß eines der genannten Kupplungs- oder Verbindungselemente (33) wie ein Block geformt ist mit einem zentralen kubischen Körper (34) von dem drei Fortsätze (35, 36 und 37) mit quadratischem Querschnitt ausgehen, die den Ausmaßen des genannten quadratischen Raums (10) des Profils entsprechen.

10. Abgedichteter Metallschrank nach Anspruch 9, dadurch gekennzeichnet, daß der genannte zentrale Körper (34) mit einem Loch mit Gewinde versehen ist, in das die mit Gewinde versehene Ende (41) einer Ringschraube (40) für das Heben des Schranks oder ein Hebefuß eingeschraubt werden kann, und der genannte zentrale Körper ist weiter mit einem Vorsprung (39) auf der Seite des mit einem Gewinde versehenen genannten Loches (38) ausgestattet.

11. Abgedichteter Metallschrank nach den vorstehenden Ansprüchen, dadurch gekennzeichnet, daß an den Abschnitten (18, 19) der genannten inneren Seitenschenkel (11, 12) Löcher (24, 27) mit unterschiedlichen und alternierenden Durchmessern angebracht sind.

12. Struktur, besonders geeignet zur Aufnahme von elektrischen und elektronischen Apparaturen, die zwei oder mehr Metallschränke nach den vorstehenden Ansprüchen umfaßt, welche auf eine aneinanderliegende und gekoppelte Weise angeordnet sind, dadurch gekennzeichnet, daß zwischen zwei parallele und sich gegenüberliegende Rahmenschenkel (1A, 11D), die zu zwei anderliegenden Rahmenstrukturen gehören, ein Flansch (40) mit einem offenen m-förmigen Querschnitt gesetzt ist, wobei die Schenkel (41, 42) des genannten Flansch (40) mit Löchern (45) versehen sind, die jeweils auf den Aussenseitenschenkeln (13, 14) der symmetrischen Profile der beiden Rahmenschenkel (1A, 11D) aneinanderstoßen, wobei der genannte Flansch (40) an Gewindehülsen befestigt ist, welche an den genannten äusseren Seitenschenkeln (13, 14) durch Schrauben, welche durch die genannten Löcher (45) des Flansches gehen, angebracht sind, und weiter wird die Struktur dadurch gekennzeichnet, daß eine Dichtung (50) zwischen die genannten Dichtungsstreifen (20, 21) der beiden Rahmenschenkel (1A, 11D) gesetzt ist und entlang der Kante angedrückt wird.

13. Struktur nach Anspruch 12, dadurch gekennzeichnet, daß die genannte Dichtung (50) einen im wesentlichen rechteckigen Querschnitt hat, mit einer leichten Abschrägung auf beiden Seiten, und sie sieht einen inneren Ablauf (51) und zwei gegenüberliegende Kanäle (52, 53) vor, zwischen denen die genannten Dichtungsstreifen angeordnet sind.

14. Vorgang zur Herstellung eines symmetrischen Profils, das mit einem quadratischen Innenraum (10) versehen ist, für die Konstruktion von Schränken entsprechend den Ansprüchen von 1 bis 11, wobei von einem ebenen Metallblech (60) ausgegangen wird, wobei der Vorgang durch die folgenden Schritte gekennzeichnet wird:
a) Ausführung einer ersten rechtwinkligen Biegung in mittlerer Position, um so ein Zweiflach zu bilden, dessen Ecke eine Aussenkante (15) des Profils bildet;
b) Rechtwinkliges Biegen (P2A, P2B) eines jeden der beiden Seitenschenkel des Zweiflachs in mittlerer Position und in die entgegen gesetzte Richtung der ersten Biegung (P1), um so zwei externe Seitenschenkel (13, 14) des Profils (10) zu bilden;
c) Biegen (P3A, P3B) eines jeden der Abschlußelemente des gefalteten Metallblechs entsprechend einem Winkel von ca. 135° in entgegengesetzter Richtung im Vergleich zu den Biegungen (P2A, P2B) des Schrittes b), um so die genannten ersten (16) und zweiten (17) Verbindungsabschnitte zu bilden, und
d) Vervollständigung der genannten letzteren Biegungen (P3A, P3B) um einen weiteren Winkel von ca. 45° bis zum Überlappen der genannten inneren Seitenschenkel (11, 12) der genannten Verbindungsabschnitte (16, 17).

15. Vorgang nach Anspruch 14, dadurch gekennzeichnet, daß der Schritt d) durch das Drücken der genannten inneren Seitenschenkel (12, 11) gegen die genannten Verbindungsabschnitte (16, 17) realisiert wird.

## Revendications

1. Armoire métallique étanche pour contenir en particulier de l'équipement électrique et électronique, qui comprend un structure formée par douze tronçons structuraux avec le même profil connectés entr'eux, sur lesquels se fixent des panneaux extérieurs (4, 5, 6, 7, 8) et des portes (9) pourvus des jointes d'étanchéité, la coupe transversale des tronçons structuraux comprend un premier (13) et un deuxième côté latéral extérieur, qui s'étendent essentiellement de manière perpendiculaire entr'eux, et un premier (11) et un deuxième (12) côté latéral intérieur, qui s'étendent substantiellement de manière perpendiculaire entr'eux, le dit premier (13) et deuxième (14) côté latéral extérieur étant respectivement connectés au dit premier (11) et deuxième (12) côté latéral intérieur par une première (16) et une deuxième (17) portions de connexion, qui s'ajoutent au dit premier (13) et deuxième (14) côté latéral extérieur à l'aide de deux pliages à 90°, la combinaison des dits côtes latéraux (13, 14, 11, 12) formant une cavité carrée (10) à l'intérieur des tronçons structuraux,
caractérisée en ce que:
- le dit profil est symétrique par rapport au plan (P) diagonal passant à travers et coupant en deux l'angle d'intersection du plan contenant les dits côtés latéraux extérieurs (13, 14);
- le bord d'extrémité de la première (16) portion de connexion en coopération avec et connectée au bord d'extrémité du dit premier (11) côté latéral intérieur, et le bord d'extrémité de la dite deuxième portion de connexion en coopération avec et connectée au bord d'extrémité du dit deuxième (12) côté latéral intérieur forment des entretoises de fermeture (20, 21), chacune apte à compresser le long du bord soit une garniture d'étanchéité (32) des dits panneaux extérieurs (4, 5, 6, 7, 8) et de la porte (9), soit une garniture (50) placée entre deux armoires jointes latéralement.

2. Armoire métallique étanche selon la revendication 1, caractérisée en ce que le dit profil est réalisé au moyen d'une seule plaque de métal avec des bords d'extrémité de la plaque libres restant substantiellement dans une position jouxtante sans être mécaniquement connectés le long de la ligne d'intersection des plans contenants les dits côtés latéraux intérieurs (11, 12).

3. Armoire métallique étanche selon la revendication 1, caractérisée en ce que sur les dits côtés latéraux extérieurs (13, 14) du profil des trous ont été mis pour recevoir des douilles filetées (29), qui s'appliquent aux extrémités des vis (28) pour fixer les panneaux (4 - 8) aux tronçons structuraux.

4. Armoire métallique étanche selon la revendication 3, caractérisée en ce que les dits panneaux (5, 6) sont formés par des plaques métalliques, qui sont pliées substantiellement à 90° le long des bords pour former des ailes (5A, 6A).

5. Armoire métallique étanche selon la revendication 3, caractérisée en ce que la dite porte (9) est formée par une plaque métallique substantiellement pliée à 90° le long des bords pour former des ailes et fixée à l'aide de charnières à la structure en correspondance des côtés extérieurs du'profil.

6. Armoire métallique étanche selon la revendication 3, caractérisée en ce que en correspondance des angles elle est pourvue d'une structure à chéneau ou dédale formée par des panneaux, qui se touchent par leurs ailes (5A, 6A) et par les tronçons structuraux sur lesquels les dits panneaux sont montés.

7. Armoire métallique étanche selon la revendication 6, caractérisée en ce que le dit dédale comprend un premier passage (25) défini entre les ailes d'un panneau (5, 6) et d'un panneau ou d'une porte jouxtante (9), et un deuxième passage (26) formé entre le bord libre (5A) d'un panneau ou l'angle extérieur (15) formé par le dit premier (13) et deuxième (14) côté latéral extérieur.

8. Armoire métallique étanche selon les revendications précédentes, caractérisée en ce que les tronçons structuraux (1A, 1B, 1C, 1D, 2A, 2B, 2C, 2D, 3A, 3B, 3C, 3D), qui forment la structure sont reliés par des éléments de couplage soudés (33).

9. Armoire métallique étanche selon la revendication 8, caractérisée en ce que chacun des dits éléments de couplage ou éléments de jonction (33) est formé comme un bloc avec un corps central en forme de cube, duquel s'étendent trois appendices (35, 36, et 37) avec une section transversale carrée, qui correspond à la dimension de la dite cavité carrée (10) du profil.

10. Armoire métallique étanche selon la revendication 9, caractérisée en ce que le corps central (34) est pourvu d'un trou fileté dans lequel on peut visser l'extrémité filetée (41) d'un boulon à oeil pour soulever l'armoire ou un pied élévateur, et le dit corps central est en plus pourvu d'une saillie (39) sur la face avec le dit trou fileté (38).

11. Armoire métallique étanche selon les revendications précédentes, caractérisée en ce que sur les portions (18, 19) des dits côtés latéraux intérieurs (11, 12) des trous avec des diamètres différents et alternants sont prévus.

12. Structure, en particulier pour contenir de l'équipement électrique et électronique, qui comprend deux ou plusieurs armoires métalliques selon une des revendications précédentes, qui sont arrangées d'une manière jouxtante et reliée, caractérisée en ce que entre deux tronçons structuraux (1A, 11D) parallèles et opposés appartenants à deux structures jouxtantes, un collet (40) ayant la coupe ouverte à M est mis, les jambes du dit collet (40) pourvues de trous (45), qui sont contigus respectivement sur le côtés latéraux extérieurs (13, 14) des profils symétriques des deux tronçons structuraux (1A, 11D), le dit collet (40) étant fixé à des douilles filetées (29) appliquées aux côtés latéraux extérieurs (13, 14) à l'aide de vis, qui passent à travers les dits trous (45) du collet, et caractérisée en plus en ce qu'une garniture d'étanchéité (50) est mise et compressée le long du bord entre les dites entretoises de fermeture (20, 21) des deux tronçons structuraux (1A, 11D).

13. Structure selon la revendication 12, caractérisée en ce que la dite garniture d'étanchéité (50) a un profil transversal substantiellement rectangulaire avec les deux bords légèrement fuselés, et elle comprend un caniveau (51) et deux canaux latéraux opposés (52, 53), entre lesquels sont arrangés les dites entretoises de fermeture (20, 21) des deux tronçons structuraux.

14. Procédure pour la réalisation d'un profil symétrique pourvu d'une cavité carrée interne (10) pour la construction d'armoires selon une des revendications de 1 à 11 partant d'une plaque métallique plane (60), la dite procédure étant caractérisée par les pas suivants:
a) réalisation d'un premier pliage à 90° (P1) dans une position médiane pour former un dièdre dont l'angle forme l'angle extérieur (15) du profil;
b) pliage (P2A, P2B) de chacun des deux côtés latéraux du dièdre à 90° dans une position intermédiaire et dans la direction opposée du dit premier pliage (P1) pour former les deux côtés latéraux extérieurs (13, 14) du profil (10);
c) pliage (P3A, P3B) de chacun des ailes d'extrémité de la plaque métallique pliée selon un angle d'environ 135° dans la direction opposée par rapport aux pliages (P2A, P2B) du pas b) pour former la dite première (16) et deuxième (17) portion de connexion, et
d) achèvement des dits derniers pliages (P3A, P3B) par un autre pliage d'environ 45° jusqu'à la superposition des dits côtés latéraux intérieurs (11, 12) aux dites portions de connexion (16, 17).

15. Procédure selon la revendication 14, caractérisée en ce que le pas d) est réalisé par la pression des dits côtés latéraux (11, 12) contre les dites portions de connexion (16, 17).
